# EUROPEAN PATENT SPECIFICATION

(11) **EP 1 528 119 B1**
(45) Date of publication and mention of the grant of the patent: **13.06.2007**
(21) Application number: 04025435.1
(22) Date of filing: 26.10.2004
(51) Int. Cl.: C23C 14/14, C23C 14/34, G11B 11/00

(54) **Aluminum-alloy sputtering target and reflective film**
Sputtertarget aus einer Aluminiumlegierung, und reflektierender Film.
Cible de pulvérisation en alliage d'aluminum et film réflecteur.

(30) Priority: 30.10.2003 JP 2003370740
(43) Date of publication of application: 04.05.2005
(73) Proprietor: Kabushiki Kaisha Kobe Seiko Sho (Kobe Steel, Ltd.), Kobe-shi, Hyogo 651-8585 (JP)
(72) Inventor: Nakai, Junichi Kobe Corp. Research Laboratories -, Nishi-ku Kobe-shi Hyogo 651-2271 (JP); Tauchi, Yuuki Kobe Corp. Research Laboratories -, Nishi-ku Kobe-shi Hyogo 651-2271 (JP); Takagi, Katsutoshi Kobe Corp. Research Lab. -, Nishi-ku Kobe-shi Hyogo 651-2271 (JP)
(74) Representative: TBK-Patent

(56) References cited:
- US-A- 5 500 301
- US-A- 5 654 058
- PATENT ABSTRACTS OF JAPAN vol. 1995, no. 04, 31 May 1995 (1995-05-31) & JP 7 011426 A (KOBE STEEL LTD), 13 January 1995 (1995-01-13)

## Description

The invention relates to a technical field concerning an aluminum-alloy reflection film for optical information-recording, an optical information-recording medium, and an aluminum-alloy sputtering target for formation of an aluminum-alloy reflection film for optical information-recording, and in particular, to a technical field concerning a reflection film having high reflectance, together with low thermal conductivity, low melting temperature, and high corrosion resistance to enable marking of a disc with the use of a laser, and so forth, after formation of the disc, in the case of a medium (ROM) for reproducing only, particularly among optical information-recording media such as CD, DVD, Blue-ray Disc, HD-DVD, and so forth, a sputtering target for formation of the reflection film, and an optical information-recording medium provided with the reflection film.

### Related Art

There are several kinds of optical discs, and on the basis of recording reproduction principles, the optical discs are broadly classified into three kinds, that is, a read only type, write once type, and rewritable type.

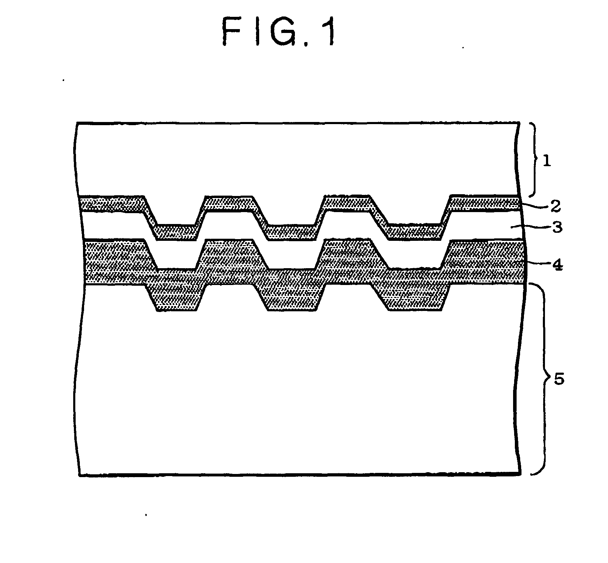

Among those, an optical disc for reproducing only has a construction in which a reflection film layer formed of Al, Ag, Au, and so forth, as a matrix, is provided after forming recording data at the time of fabrication according to pits and lands provided on a transparent plastic base body, as shown in Fig. 1 by way of example, and at the time reading data, data reproducing is executed by detecting phase difference and reflection difference of a laser beam emitted to the disc. Further, there is another type of optical disc for reading data recorded in two layers, fabricated by laminating two sheets of base members with each other, that is, the base member with a reflection film layer, and the base member provided with a translucent reflection layer, over individual recording pits formed, respectively. With this recording-reproducing type, a disc face on one side is for data read only (write and rewrite inhibit), and as an optical disc of this type, there are cited CD-ROM, DVD-ROM, BD-ROM, HD-DVD-ROM, and so forth. Fig. 1 is a schematic illustration showing a construction of an optical disc, in section, and in the figure, reference numeral 1 denotes a polycarbonate base body, 2 a translucent reflection layer (Au, Ag alloy, Si),3 an adhesion layer, 4 a total reflection film layer (Al alloy), and 5 a UV-curing resin protection layer.

Such optical discs for reproducing only are produced on a large scale by press working using a stamper with an information pattern formed beforehand at the time when the discs are fabricated, so that it has been difficult to provide individual discs with IDs, respectively. However, for the purposes of prevention of illegal copies of discs, enhancement in traceability of products in distribution, enhancement in added values, and so forth, even with the optical discs for reproducing only, there has been seen a start of a tendency that discs of the level-gate type, BCA (Burst Cutting Area) type, and so forth, with IDs recorded for the individual discs, respectively, by use of a dedicated apparatus, after the formation of the discs, become the norm. At present, such marking of a disc with an ID is implemented mainly by a method whereby an aluminum-alloy of a reflection film is melted by emitting a laser beam to the disc after fabricated, thereby boring holes in the reflection film.

For the reflection film of the optical disc for reproducing only, widespread use has since been made of Al-alloys mainly according JIS6061 (an Al-Mg alloy), which are large in distribution quantity as a common structural material, and as such, are inexpensive.

However, since the Al-alloys of JIS6061 series are not material intended for use in applying laser marking thereto, the following points under (1) and (2) below are yet to be resolved.
(1) The Al-alloy is high in thermal conductivity. More specifically, in order to apply laser marking at a low output, the thermal conductivity of the reflection film is preferably as low as possible, however, the Al-alloys of JIS6061 series are too high in thermal conductivity. Therefore, in the case of applying laser marking with the use of the Al-alloys of JIS6061 series, in the present state, there has occurred a problem of the polycarbonate base body and the reflection film, making up the disc, undergoing thermal damage because laser output has been excessively large.
(2) The Al-alloys are low in corrosion resistance. More specifically, when laser marking is applied, voids are formed after the laser marking, so that initiation of corrosion occurs to an Al-alloy film during a constant temperature and moisture test to be conducted later on.

As to reduction in thermal conductivity of an Al-alloy reflection film, there has been disclosed a method of reducing thermal conductivity by adding elements such as Nb, Ti, Ta, W, Mn, Mo, and so forth, to Al in, for example, JP - A No. 177639 / 1992 (Patent document 1) relating to the field of a reflection film for an opto-magnetic recording. Further, in JP -.A No. 12733 / 1993 (Patent document 2), there has been disclosed a method of reducing thermal conductivity by adding at least one element selected from the group consisting of elements Si, Ti, Ta, Cr, Zr, Mo, Pd, and Pt to Al. Still further, in JP - A No. 11426 / 1995 (Patent document 3), there has been disclosed an alloy film obtained by adding W, or Y to Al. However, because those reflection films are not developed on the premise that melting as well as removal of a film is implemented by emitting a laser beam thereto, there are some which can attain reduction in thermal conductivity, but, at the same time, rises in melting temperature while there are others which do not take into account a problem of the corrosion due to the voids, occurring after the marking, as described above. Thus, none meeting requirements as the Al-alloy for use in laser marking has been provided as yet.
(Patent document 1) JP - A No. 177639 / 1992
(Patent document 2) JP - A No. 12733 / 1993
(Patent document 3) JP - A No. 11426 / 1995

US Patent No. 5,654,058 describes a magneto-optical disk for recording in which the thermal conductivity of the metallic protective layer can be controlled by a metallic layer material from at least one of Al, Au, Pt, Rh, Pd and Cu as the host element or an alloy with another element or by adjusting the thickness of the metallic layer.

The US Patent No. 5,500,301 describes an Al alloy film and an Al alloy sputtering target for depositing the Al alloy film, wherein the film can be used as a reflection film for an optical recording medium. The alloy components are selected from the group of Ti, Zr, Hf, V, Nb, Ta, Cr, Mo and Mn in a total amount of 0.1 to 10 at. %. If such an alloying element is used, the thermal conductivity of the Al alloy film can be significantly reduced, especially in comparison to an Al-Cu alloy film.

### SUMMARY OF THE INVENTION

As described in the foregoing, the Al-alloy capable of coping with laser marking needs to have low thermal conductivity, low melting temperature, and high corrosion resistance.

However, the Al-alloys of JIS6061 series for use as a reflection film of an optical disc for reproducing only are high in thermal conductivity, and low in corrosion resistance, and have difficulty in coping with laser marking applications in respect of these points. Further, in the field of the Al alloy reflection film for the opto-magnetic recording, the Al-alloy reflection films (as disclosed in Patent documents 1 to 3) so far proposed have difficulty in coping with the laser marking applications as described above.

The present invention has been developed by focusing attention on those circumstances, and it is therefore an object of the invention to provide an aluminum-alloy reflection film for optical information-recording, having low thermal conductivity, low melting temperature, and high corrosion resistance, and capable of coping with laser marking, an optical information-recording medium provided with the aluminum-alloy reflection film, and an aluminum-alloy sputtering target for formation of the aluminum-alloy reflection film.

To that end, the inventor, et al. have continued strenuous researches, and as a result, have obtained knowledge that a thin film of an aluminum alloy obtained by causing specific amounts of specific alloying elements to be contained in aluminum has low thermal conductivity, low melting temperature, and high corrosion resistance, and as such, is a reflection thin film layer (metallic thin film layer) suitable for use as a reflection film for optical information-recording, capable of coping with laser marking. The present invention has been developed on the basis of such knowledge, and the object described as above can be achieved by the present invention.

The present invention that has achieved the object described upon completion as above is concerned with an aluminum-alloy reflection film for optical information-recording, an optical information-recording medium, and an aluminum-alloy sputtering target for formation of the aluminum-alloy reflection film for optical information-recording. In accordance with a first aspect of the present invention, there is provided the aluminum-alloy reflection film for optical information-recording (the aluminum-alloy reflection film according to first to fifth inventions), and the present invention in its second aspect provides the optical information-recording medium (the optical information-recording medium according to sixth to seventh inventions), further providing in its third aspect the aluminum-alloy sputtering target for formation of an aluminum-alloy reflection film for optical information-recording (the sputtering target according to eighth to eleventh inventions). Those have the following makeup, respectively.

More specifically, the aluminum-alloy reflection film for optical information-recording according to the present invention is an aluminum-alloy reflection film for optical information-recording, serving as an aluminum-alloy reflection film for use in an optical information-recording medium, said aluminum-alloy reflection film for optical information-recording, containing:
an element Al as the main constituent;
   1.0 to 10.0 aft. % of at least one element selected from the group of rare earth elements;
   0.5 to 5.0 at. % of at least one element selected from the group consisting of elements Cr, Ta, Ti, Mo, V, W, Zr, Hf, Nb, and Ni; and;
   1.0 to 10.0 at. % of at least one element selected from the group of elements In, Zn, Ge, Cu, and Li (the first invention).

With these features, the rare earth elements may be elements Nd and / or Y (the second embodiment).

Any of the aluminum-alloy reflection films for optical information-recording, described as above, may contain 1.0 to 5.0 at. % of at least one element selected from the group consisting of elements Fe, and Co (the third embodiment).

Any of the aluminum-alloy reflection films for optical information-recording, described as above, contain 1.0 to 10.0 at. % of at least one element selected from the group consisting of elements In, Zn, Ge, Cu, and Li.

Any of the aluminum-alloy reflection films for optical information-recording, described as above, may contain not more than 5.0 at. % of at least one element selected from the group consisting of elements Si, and Mg (the fourth embodiment).

The optical information-recording medium according to the second aspect of the present invention comprises any of the aluminum-alloy reflection films described as above (the fifth embodiment).

The optical information-recording medium described as above may be suitable for use in laser marking (the sixth embodiment).

The aluminum-alloy sputtering target for formation of an aluminum-alloy reflection film for optical information-recording, according to the present invention, containing:
an element Al as the main constituent;
   1.0 to 10.0 at. % of at least one element selected from the group of rare earth elements; and
   0.5 to 5.0 at. % of at least one element selected from the group consisting of elements Cr, Ta, Ti, Mo, V, W, Zr, Hf, Nb, and Ni; and;
   1.0 to 10.0 at. % of at least one element selected from the group of elements In, Zm, Ge, Cu, and Li (the seventh embodiment).

The aluminum-alloy sputtering target for formation of seventh embodiment an aluminum-alloy reflection film for optical information-recording, described as above, may contain 1.0 to 5.0 at. % of at least one element selected from the group consisting of elements Fe, and Co (the eighth embodiment).

Any of the aluminum-alloy sputtering targets for formation of an aluminum-alloy reflection film for optical information-recording, described as above, contain 1.0 to 10.0 at. % of at least one element selected from the group consisting of elements In, Zn, Ge, Cu, and Li.

Any of the aluminum-alloy sputtering targets for formation of an aluminum-alloy reflection film for optical information-recording, described as above, may contain not more than 5.0 at. % of at least one element selected from the group consisting of elements Si, and Mg (the ninth embodiment).

The aluminum-alloy reflection film for optical information-recording according to the present invention can have low thermal conductivity, low melting temperature, and high corrosion resistance, and can be suitably used as a reflection film for optical information-recording, capable of coping with laser marking. The optical information-recording medium according to the present invention comprises the aluminum-alloy reflection film described, and laser marking can be suitably applied thereto. The aluminum-alloy sputtering target for formation of an aluminum-alloy reflection film for optical information-recording, according to the present invention, can form the aluminum-alloy reflection film described.

### BRIEF DESCRIPTION OF THE DRAWING

Fig. 1 is a schematic sectional view showing a construction of an optical disc for reproducing only.

### DETAILED DESCRIPTION OF THE PREFERRED EMBODIMENTS

An aluminum-alloy thin-film suitable for laser marking needs to have low thermal conductivity, low melting temperature, and high corrosion resistance.

The inventor, et al. have produced aluminum-alloy sputtering targets obtained by adding a variety of elements to aluminum, respectively, and have fabricated aluminum-alloy thin-films of various compositions by a sputtering method using those sputtering targets, thereby having examined the composition thereof, and properties thereof, as a reflection thin film layer, whereupon the following facts (items (1) to (5) as given below) have been found out:
(1) By adding at least one element selected from the group of rare earth elements, in a range of 1.0 to 10.0 at. % in total, to aluminum, thermal conductivity can be significantly reduced without causing a rise in melting temperature (liquid phase line temperature). If an addition amount of the one element is less than 1.0 at. %, the effect of reduction in thermal conductivity decreases. If the addition amount of the one element exceeds 10.0 at. %, deterioration in reflectance increases. Among the group of the rare earth elements, Nd and Y have greater effect of reduction in thermal conductivity, respectively. Further, as for corrosion resistance, an advantageous effect obtained by addition of the above-described rare earth elements only is insufficient.
(2) By further adding at least one element selected from the group consisting of elements Cr, Ta, Ti, Mo, V, W, Zr, Hf, Nb, and Ni, in a range of 0.5 to 5.0 at . % in total, to aluminum while adding the one element selected from the group of the rare earth elements, in the range of 1.0 to 10.0 at. % in total, to aluminum, as above, corrosion resistance can be significantly improved. In addition, those elements (Cr, Ta, Ti, Mo, V, W, Zr, Hf, Nb, and Ni (hereinafter referred to also as (Cr to Nb, Ni)) also contribute to reduction in thermal conductivity. However, because those elements (Cr to Nb, Ni) cause the melting temperature (liquid phase line temperature) thereof to considerably rise while causing the reflectance thereof to deteriorate, an addition amount thereof is limited, and needs to be not more than 5. 0 at. %, preferably not more than 3. 0 at. %. If the addition amount of those elements (Cr to Nb, Ni) is less than 0.5 at. %, the effect of improvement in corrosion resistance decreases. Hence, the addition amount is preferably 1.0 at. % or more. Among those elements (Cr to Nb, Ni), Cr, Ta, Ti, and Hf are preferably selected in the effect of a marked improvement in corrosion resistance.
(3) By adding at least the one element selected from the group of those elements (Cr to Nb, Ni), in the range of 0. 5 to 5.0 at. % in total, to aluminum while at least the one element selected from the group of the rare earth elements, in the range of 1.0 to 10.0 at. % in total, is added to aluminum, described as above {as described under item (2) above}, and by further adding thereto at least one element selected from the group consisting of elements Fe, and Co, in a range of 1.0 to 5.0 at. % in total, thermal conductivity can be reduced. If an addition amount of those elements (Fe, Co) is less than 1.0 at. %, the effect of reduction in thermal conductivity decreases, and in order to sufficiently exhibit the effect of reduction in thermal conductivity, not less than 1.0 at. % of those elements (Fe, Co) are preferably added thereto. Because of an increase in deterioration of reflectance if those elements (Fe, Co) are excessively added, and because of ease with which a sputtering target is produced, the addition amount of those elements (Fe, Co) is preferably set to not more than 5.0 at. %,
(4) By adding at least the one element selected from the group of those elements (Cr to Nb, Ni), in the range of 0. 5 to 5.0 at. % in total, to aluminum while at least the one element selected from the group of the rare earth elements, in the range of 1.0 to 10.0. at, % in total, is added to aluminum, described as above {as described under item (2) above}, and by further adding thereto at least one element selected from the group consisting of elements In, Zn, Ge, Cu, and Li, in a range of 1.0 to 10.0 at. % in total, thermal conductivity and melting temperature can be reduced. If an addition amount of those elements (In, Zn, Ge, Cu, and Li (hereinafter referred to also as (In to Li)) is less than 1.0 at. %, the effect of reduction in thermal conductivity, and the effect of reduction in melting temperature decrease, and in order to sufficiently exhibit the effect of reduction in thermal conductivity, and the effect of reduction in melting temperature, not less than 1.0 at. % of those elements (In to Li) are added. Because of an increase in deterioration of reflectance if those elements (In to Li) are excessively added, the addition amount of those elements (In to Li) is set to not more than 10.0 at. %.
(5) By adding at least the one element selected from the group of those elements (Cr to Nb, Ni), in the range of 0.5 to 5. 0 at. % in total, to aluminum while at least the one element selected from the group of the rare earth elements, in the range of 1.0 to 10.0 at. % in total, is added to aluminum, described as above {as described under item (2) above}, and by further adding thereto not more than 5.0 at. % of at least one element selected from the group consisting of elements Si, and Mg, melting temperature can be reduced. Further, among those elements (Si, Mg), Si also has the effect of improvement in corrosion resistance. Further, those elements (Si, Mg) do not have effect of reduction in thermal conductivity. In order to sufficiently exhibit the effect of reduction in melting temperature, not less than 1.0 at. % of those elements (Si, Mg) are preferably added. Because of an increase in deterioration of reflectance if those elements (Si, Mg) are excessively added, and because of ease with which a sputtering target is produced, an addition amount of those elements (Si, Mg) is preferably set to not more than 5.0 at. %.

The invention has been developed based on the knowledge described as above, and intends to provide an aluminum-alloy reflection film of the above-described composition, for optical information-recording, an optical information-recording medium, and an aluminum-alloy sputtering target for formation of the aluminum-alloy reflection film for optical information-recording.

An embodiment of an aluminum-alloy reflection film for optical information-recording according to the invention, completed as described above, is an aluminum-alloy reflection film for use in the optical information-recording medium, and is an aluminum-alloy reflection film for optical information-recording, containing Al as the main constituent, and 1.0 to 10.0 at. % of at least one element selected from the group of rare earth elements, further containing 0. 5 to 5.0 at. % of at least one element selected from the group consisting of elements Cr to Nb, Ni (Cr, Ta, Ti, Mo, V, W, Zr, Hf, Nb, and Ni) (a first invention).

As is evident from the items (1) and (2) above, with the aluminum-alloy reflection film for optical information-recording, by adding at least the one element selected from the group of the rare earth elements, in the range of 1.0 to 10.0 at. % in total, the thermal conductivity thereof can be significantly reduced without causing a rise in the melting temperature (liquid phase line temperature) thereof, and by further adding 0.5 to 5.0 at. % of at least the one element selected from the group consisting of elements Cr to Nb, Ni, the corrosion resistance can be significantly improved, and the thermal conductivity thereof can be further reduced.

Accordingly, the aluminum-alloy reflection film for optical information-recording according to the invention can have low thermal conductivity, low melting temperature, and high corrosion resistance, and is capable of excellently coping with laser marking, so that the same can be used suitably as a reflection film for optical information recording. That is, since the melting temperature is low, the laser marking can be easily applied, and since the thermal conductivity is low, it need only be sufficient to have low laser output (with no need for excessively increasing laser output), thereby precluding a possibility of thermal damage otherwise occurring to disc components (a polycarbonate sheet and an adhesion layer) due to excessive laser output. Furthermore, since the same is excellent in corrosion resistance, it is possible to prevent initiation of corrosion during a constant temperature-and-moisture test conducted after the laser marking (corrosion occurring to the aluminum-alloy reflection film, due to moisture intruding into voids formed after the laser marking) .

With the aluminum-alloy reflection film for optical information-recording according to the invention, if Nd and / or Y are used as the rare earth elements, the thermal conductivity can be more significantly reduced as is evident from the item (1) as above (a second invention).

With the aluminum-alloy reflection film for optical information-recording according to the invention, if 1.0 to 5.0 at. % of at least the one element selected from the group consisting of elements Fe, and Co is further contained therein, the thermal conductivity can be further significantly reduced as is evident from the item (3) as above a third embodiment.

With the aluminum-alloy reflection film for optical information-recording according to the invention, if 1.0 to 10.0 at. % of at least the one element selected from the group consisting of elements In to Li (In, Zn, Ge, Cu, and Li) is further contained therein, the melting temperature can be reduced and the thermal conductivity can be still further reduced as is evident from the item (4) as above.

With the aluminum-alloy reflection film for optical information-recording according to the invention, if not more than 5.0 at. % of at least the one element selected from the group consisting of elements Si, and Mg, the melting temperature can be reduced as is evident from the item (5) as above (a fourth embodiment). Further, among those elements (Si, Mg), Si also has the effect of improvement in the corrosion resistance.

With the invention, the aluminum-alloy reflection film for optical information-recording is preferably formed to a thickness in a range of 30 to 200 nm. The reason for this is because although it is considered that the smaller the film thickness thereof, the easier the laser marking can be applied, if the film thickness thereof is as small as less than 30 nm, light is transmitted therethrough, resulting in deterioration of reflectance while surface flatness of the film deteriorates as the film thickness increases, thereby causing light to become prone to scattering, and with the film thickness in excess of 200 nm, the aluminum-alloy reflection film for optical information becomes susceptible to scattering of light. From the viewpoint of checking the deterioration of reflectance, and the scattering of light, the film thickness is more preferably set to fall in a range of 40 to 100 nm.

An embodiment of an optical information-recording medium, according to the invention, comprises the above-described aluminum-alloy reflection film for optical information-recording according to the invention (a fifth embodiment). The laser marking can be suitably applied to the optical information-recording medium. Accordingly, it is possible to prevent thermal damage otherwise occurring to the disc components (the polycarbonate sheet and the adhesion layer) due to excessive laser output. Furthermore, since the aluminum-alloy reflection film is excellent in the corrosion resistance, the same is insusceptible to initiation of corrosion during the constant temperature-and-moisture test conducted after the laser marking (corrosion otherwise occurring to the aluminum-alloy reflection film, due to moisture intruding into voids formed after the laser marking) . In these respects, the optical information-recording medium can have excellent properties.

As the optical information-recording medium according to the invention can have the excellent properties as described above, and the same can be particularly suitably used in laser marking (a sixth embodiment).

An embodiment of an aluminum-alloy sputtering target, according to the invention, is an aluminum-alloy sputtering target for formation of the aluminum-alloy reflection film for optical information-recording, containing Al as the main constituent, and 1.0 to 10.0 at. % of at least the one element selected from the group of rare earth elements while containing 0.5 to 5.0 at. % of at least the one element selected from the group consisting of elements Cr to Nb, Ni (Cr, Ta, Ti, Mo, V, W, Zr, Hf, Nb, and Ni) (a seventh embodiment). With the use of the aluminum-alloy sputtering target, the aluminum-alloy reflection film for optical information-recording according to the first invention can be formed.

If the aluminum-alloy sputtering target, according to the invention, further contains 1.0 to 5.0 at. % of at least the one element selected from the group consisting of elements Fe, and Co, the aluminum-alloy reflection film for optical information-recording according to the third embodiment can be formed (an eighth embodiment).

If the aluminum-alloy sputtering target, according to the invention, still further contains 1.0 to 10.0 at. % of at least the one element selected from the group consisting of elements In to Li (In, Zn, Ge, Cu, and Li), the aluminum-alloy reflection film for optical information-recording according to the invention can be formed.

If the aluminum-alloy sputtering target, according to the invention, yet further contains not more than 5.0 at. % of at least the one element selected from the group consisting of elements Si, and Mg, the aluminum-alloy reflection film for optical information-recording according to the fifth invention can be formed (a ninth embodiment).

### Working Examples

Working examples, and comparative examples of the present invention will be described hereinafter.

### Comparative Example 1

An Al-Nd (an Al alloy containing Nd) thin film, and an Al-Y (an Al alloy containing Y) thin film were fabricated, having examined relationships of respective addition amounts (respective contents) of Nd, Y, with the melting temperature, thermal conductivity, reflectance of the respective thin films, and BCA (Burst Cutting Area) marking property, respectively.

The thin films were fabricated as follows. More specifically, the Al-Nd thin film, or the Al-Y thin film was fabricated (formed) on a glass substrate (Corning #1737, substrate size; 50 mm in diameter, 1 mm in thickness) by DC magnetron sputtering. At this point in time, there were adopted film forming conditions of substrate temperature: 22°C, Ar gas pressure: 2 mTorr, film forming rate: 2 mm / sec, and back pressure: < 5 x 10⁻⁶ Torr. For a sputtering target, use was made of an aluminum-alloy sputtering target of the same composition as that for the Al alloy thin film that is to be obtained.

The respective melting temperatures of the thin films were measured in the following manner. About 5 mg of the respective aluminum-alloy thin films (the Al-Nd thin film, and the Al-Y thin film) formed to a thickness 1 µm were collected after being stripped from the substrate to be measured with a differential thermometer. In this case, the mean value of temperature at the time of the close of film melting in increasing temperature, and temperature at the time of the start of film solidification in decreasing temperature was taken as melting temperature. The thermal conductivity was obtained by conversion from electrical resistivity of the respective aluminum-alloy thin films formed to a thickness 100 nm. The reflectance was found by measuring reflectance of the respective films 100 nm thick at the laser wave length 650 nm and 405 nm as currently adopted in the case of DVD. Tests on BCA marking property were conducted using a PC (polycarbonate) base plate 0.6 mm thick as a substrate to fabricate an Al-alloy thin film 70 nm thick although the same film forming conditions as those described above were adopted. At the tests, the thin film was irradiated with laser light (laser marking) under a laser condition of laser wavelength: 810 nm, linear velocity: 4 m / sec, and laser power: 1.5W to thereby evaluate the characteristics on the basis of an effective aperture ratio of portions of the thin film, subjected to the laser marking. Further, for evaluation, use was made of a BCA code recorder POP120 - 8R for DVD-ROM (manufactured by Hitachi Computer Equipment) . In making evaluation of the BCA marking property, described later, those with the effective aperture ratio at not less than 95% is designated as a double circle, those with the effective aperture ratio in a range of 80 to 95% as a circle, those with the effective aperture ratio in a range of 50 to 80% as a triangle, and those with the effective aperture ratio less than 50% as a cross (×).

Meanwhile, as an comparative example against the aluminum-alloy thin films described as above (the Al-Nd thin film, and the Al-Y thin film), an aluminum-alloy thin film of a composition equivalent to that for a JIS6061 material was fabricated (formed) by the same method as described above. For a sputtering target in this case, use was made of an aluminum-alloy sputtering target fabricated out of the JIS6061 material. The aluminum-alloy sputtering target had a composition of Si; 0.75 wt. % (mass %), Fe: 0.10 wt. %. Cu: 0.41 wt. %, Mn: 0.07 wt. %. Mg: 1.10 wt. %, Cr: 0.12 wt. %, and the balance being composed of Al and intrinsic impurities. An aluminum-alloy thin film as fabricated had the same composition as that of the aluminum-alloy sputtering target described above.

With the aluminum-alloy thin film of the composition equivalent to that for the JIS6061 material, measurements were made in respect of melting temperature, thermal conductivity, reflectance, and BCA marking property, respectively, by the same method described as above.

Results of the measurements (examinations) as described are shown in Table 1. In the "composition" column of Table 1, an Nd-amount, and a Y-amount of Al-Nd alloy and Al-Y alloy, respectively, refer to values expressed in at. % (atomic %) . That is, Al - x · Nd refers to an Al alloy (Al-Nd alloy) thin film containing x at. % of Nd while Al - x · Y refers to an Al alloy (Al-Y alloy) thin film containing x at. of Y. For example, Al - 1.0 Nd refers to an Al alloy containing 1.0 at. % of Nd.

As is evident from Table 1, thermal conductivity significantly deteriorates with an increase in the Nd-amount, and the Y-amount, respectively. On the other hand, melting temperature hardly changes even with an increase in the Nd-amount, and the Y-amount, respectively. Further, reflectance is found gradually deteriorating with an increase in the Nd-amount, and the Y-amount, respectively.

Thermal conductivity is found at a sufficiently good value (low value) when the Nd-amount, and the Y-amount are at not less than 1.0 at. %, respectively, and is at a higher-level good value when the Nd-amount, and the Y-amount are at not less than 2.0 at. %, respectively. Reflectance is found at a sufficiently good value (high value) when the Nd-amount, and the Y-amount are at not more than 10.0 at. %, respectively, provided, however, that the magnitude of deterioration in reflectance when the Nd-amount, and the Y-amount exceed 7 at. %, in the described range, respectively, is greater than that when the Nd-amount, and the Y-amount are at not more than 7 at. %, respectively,

Based on those results, it is evident that the respective addition amounts (contents) of Nd, and Y need to be in a range of 1.0 to 10. 0 at. %, and are more preferably in a range of 2.0 to 7 at. %.

### Comparative Example 2

An Al - 4. 0Nd - (Ta, Cr, Ti) thin film (a thin film made of an Al alloy containing 4.0 at. % of Nd, together with at least one element selected from the group consisting of elements Ta, Cr, and Ti) was fabricated, having examined relationships of respective addition amounts of Ta, Cr, and Ti, with the melting temperature, thermal conductivity, reflectance, corrosion resistance of the thin film, and BCA marking property, respectively.

The thin film was fabricated as follows. More specifically, the Al - 4. 0Nd - (Ta, Cr, Ti) alloy thin film was fabricated (formed) on a glass substrate (Corning #1737, substrate size; 50 mm in diameter, 1 mm in thickness) by DC magnetron sputtering. At this point in time, there were adopted film forming conditions of substrate temperature: 22°C, Ar gas pressure: 2 mTorr, film forming rate: 2 mm / sec, and back pressure: < 5 x 10⁻⁶ Torr. For a sputtering target, use was made of an aluminum-alloy sputtering target of the same composition as that for the Al alloy thin film that is to be obtained.

The melting temperature of the thin film was measured in the following manner. About 5 mg of the aluminum-alloy thin film {the Al - 4.0Nd - (Ta, Cr, Ti) alloy thin film} formed to a thickness 1 µm were collected after being stripped from the substrate to be measured with a differential thermometer. In this case, the mean value of temperature at the time of the close of film melting in increasing temperature, and temperature at the time of the start of film solidification in decreasing temperature was taken as melting temperature. The thermal conductivity thereof was obtained by conversion from electrical resistivity of the aluminum-alloy thin film formed to a thickness 100 nm. The reflectance was found by measuring reflectance of the respective films 100 nm thick at the laser wave length 650 nm and 405 nm as currently adopted in the case of DVD. Tests on BCA marking property were conducted using a PC (polycarbonate) base plate 0.6 mm thick as a substrate to fabricate an Al-alloy thin film 70 nm thick although the same film forming conditions as those described above were adopted. At the tests, the thin film was irradiated with laser light (laser marking) under a laser condition of laser wavelength: 810 nm, linear velocity: 4 m / sec, and laser power: 1.5W to thereby evaluate the characteristics on the basis of an effective aperture ratio of portions of the thin film, subjected to the laser marking. Further, for evaluation, use was made of a BCA code recorder POP120 - 8R for DVD-ROM (manufactured by Hitachi Computer Equipment). In making evaluation of the BCA marking property, described later, those with the effective aperture ratio at not less than 95% is designated as a double circle, those with the effective aperture ratio in a range of 80 to 95% as a circle, those with the effective aperture ratio in a range of 50 to 80% as a triangle, and those with the effective aperture ratio less than 50% as a cross (×) . As for corrosion resistance, the aluminum-alloy thin film was immersed in a solution of 5% NaCl at 35°C to thereby measure anodic polarization, from which a pitting initiation potential (a potential corresponding to current density at 10 µA / cm²) was found to be used as an index for corrosion resistance. The potential described is a potential relative to the saturated calomel electrode (SCE), that is, a potential vs. SCE (the same applies hereinafter).

Results of the measurements (examinations) as described are shown in Table 2. In the "composition" column of Table 2, an Nd-amount, a Ta amount, a Cr amount, and a Ti amount of Al - 4Nd - (Ta, Cr, Ti) refer to values expressed in at. % (atomic %), respectively. That is, Al- 4Nd - Y - Ta (or Cr, Ti) refers to an Al alloy {Al - Nd - (Ta, Cr, Ti) alloy} thin film containing 4.0 at. % Nd, together with Y at. % of Ta (or Cr, Ti) . For example, Al - 4Nd - 1.0Ta refers to an Al alloy containing 4.0 at. % of Nd, together with 1.0 at. % of Ta.

As is evident from Table 2, with an increase in respective addition amounts (contents) of Ta, Cr, and Ti, the pitting initiation potential increases (becomes more noble), resulting in enhancement of corrosion resistance. Ta, in particular, among Ta, Cr, and Ti, has the effect of large enhancement in corrosion resistance. On the other hand, with an increase in the respective addition amounts (contents) of those elements (Ta, Cr, and Ti), melting temperature increases and reflectance deteriorates, respectively.

Corrosion resistance is found at a sufficiently good value (high value) when the Ta amount, Cr amount, and Ti amount are at not less than 0.5 at. %, respectively, and is found at a higher-level good value when those amounts are at not less than 2.0 at. %, respectively. Reflectance is found at a sufficiently good value (high value) when the Ta amount, Cr amount, and Ti amount are at not more than 5.0 at. %, respectively, and is at a higher-level good value when those amounts are at not more than 4.0 at. %, respectively. Melting temperature is found at a sufficiently good value (low value) when the Ta amount, Cr amount, and Ti amount are at not more than 5.0 at. %, respectively, and is at a higher-level good value when those amounts are at not more than 4.0 at. %, respectively.

Based on those results, it is evident that the respective addition amounts (contents) of the Ta amount, Cr amount, and Ti amount need to be in a range of 0.5 to 5.0 at. %, and are more preferably in a range of 2.0 to 4.0 at. %.

Furthermore, as is evident from Tables 1 and 2, a film made of pure aluminum is unsatisfactory because the thermal conductivity thereof is high, and the pitting initiation potential thereof is low (less noble). With reference to the aluminum-alloy thin film of the composition equivalent to that for the JIS6061 material, the pitting initiation potential thereof was found low at - 744 mV although not shown in Tables, so that the corrosion resistance thereof was poor

### Comparative Example 3

An A1 - 4.0Nd- {Mo, V, W, Zr, Hf, Nb, and Ni (hereinafter referred to also as (Mo to Nb, Ni)} thin film (a thin film made of an Al alloy containing 4.0 at. % of Nd, together with at least one element selected from the group consisting of elements Mo to Nb, Ni) was fabricated, having examined relationships of respective addition amounts of Mo to Nb, Ni, with the melting temperature, thermal conductivity, reflectance, corrosion resistance of the thin film, and BCA marking property, respectively.

The thin film was fabricated as follows. More specifically, the Al - 4.0Nd - (Mo to Nb, Ni) alloy thin film was fabricated (formed) on a glass substrate (Corning #1737, substrate size; 50 mm in diameter, 1 mm in thickness) by DC magnetron sputtering. At this point in time, there were adopted film forming conditions of substrate temperature: 22°C, Ar gas pressure: 2 mTorr, film forming rate: 2 mm / sec, and back pressure: < 5 x 10⁻⁶ Torr. For a sputtering target, use was made of an aluminum-alloy sputtering target of the same composition as that for the Al alloy thin film that is to be obtained.

The melting temperature of the thin film was measured in the following manner. About 5 mg of the aluminum-alloy thin film {the Al - 4.0Nd - (Mo to Nb, Ni) alloy thin film} formed to a thickness 1 µm were collected after being stripped from the substrate to be measured with a differential thermometer. In this case, the mean value of temperature at the time of the close of film melting in increasing temperature, and temperature at the time of the start of film solidification in decreasing temperature was taken as melting temperature. The thermal conductivity thereof was obtained by conversion from electrical resistivity of the aluminum-alloy thin film formed to a thickness 100 nm. The reflectance was found by measuring reflectance of the respective films 100 nm thick at the laser wave length 650 nm and 405 nm as currently adopted in the case of DVD. Tests on BCA marking property were conducted using a PC (polycarbonate) base plate 0.6 mm thick as a substrate to fabricate an Al-alloy thin film 70 nm thick although the same film forming conditions as those described above were adopted. At the tests, the thin film was irradiated with laser light (laser marking) under a laser condition of laser wavelength: 810 nm, linear velocity: 4 m / sec, and laser power: 1.5W to thereby evaluate the characteristics on the basis of an effective aperture ratio of portions of the thin film, subjected to the laser marking. Further, for evaluation, use was made of a BCA code recorder POP120 - 8R for DVD-ROM (manufactured by Hitachi Computer Equipment). In making evaluation of the BCA marking property, described later, those with the effective aperture ratio at not less than 95% is designated as a double circle, those with the effective aperture ratio in a range of 80 to 95% as a circle, those with the effective aperture ratio in a range of 50 to 80% as a triangle, and those with the effective aperture ratio less than 50% as a cross (×) . As for corrosion resistance, the aluminum-alloy thin film was immersed in a solution of 5% NaCl at 35°C to thereby measure anodic polarization, from which a pitting initiation potential (the potential corresponding to current density at 10 µA / cm²) was found to be used as an index for corrosion resistance.

Results of the measurements (examinations) as described are shown in Tables 3 and 4. In the respective "composition" columns of Tables 3 and 4, respective amounts of No to Nb, Ni of Al - 4Nd - (Mo to Nb, Ni) refer to values expressed in at. % (atomic %), respectively. That is, Al- 4Nd - Y - Mo (or one element selected from the group consisting of elements V to Nb, Ni) refers to an Al alloy {Al - Nd - (Mo to Nb, Ni) alloy} thin film containing 4.0 at. % Nd, together with Y at. % of Mo (or the one element selected from the group consisting of elements V to Nb, Ni). For example, Al - 4Nd - 1.0Mo refers to an Al alloy containing 4.0 at. % of Nd, together with 1.0 at. % of Mo.

As is evident from Tables 3 and 4, with an increase in an addition amount (content) of any of Mo to Nb, Ni (Mo, V, W, Zr, Hf, Nb, and Ni), the pitting initiation potential thereof increases (becomes more noble), resulting in enhancement of corrosion resistance. On the other hand, with an increase in the respective addition amounts of those elements (Mo to Nb, Ni), melting temperature increases, and reflectance decreases.

Corrosion resistance is found at a sufficiently good value (high value) when the respective addition amounts (contents) of Mo to Nb, Ni are at not less than 0.5 at. %, and is at a higher-level good value when the respective addition amounts are at not less than 2.0 at. %. Reflectance is found at a sufficiently good value (high value) when the respective addition amounts of Mo to Nb, Ni are at not more than 5.0 at. %, and is at a higher-level good value when the respective addition amounts are at not more than 4.0 at. %. Melting temperature is found at a sufficiently good value (low value) when the respective addition amounts of Mo to Nb, Ni are at not more than 5.0 at. %, respectively, and is at a higher-level good value when the respective addition amounts are at not more than 4.0 at. %.

Based on those results, it is evident that the respective addition amounts (contents) of Mo to Nb, Ni need to be in a range of 0.5 to 5.0 at. %, and are more preferably in a range of 2.0 to 4.0 at. %.

### Comparative Example 4

An Al - 4.0Nd - (Fe, Co) thin film (a thin film made of an Al alloy containing 4.0 at. % of Nd, together with Fe or Co) and an Al - 4.0Nd - 1Ta - (Fe, Co) thin film (a thin film made of an Al alloy containing 4.0 at. % of Nd, and 1.0 at. % of Ta, together with Fe or Co) were fabricated, having examined relationships of respective addition amounts of Fe and Co, with the melting temperature, thermal conductivity, reflectance, corrosion resistance, and BCA marking property of the respective thin films, respectively.

The thin films were fabricated as follows. More specifically, the Al - 4.0Nd - (Fe, Co) alloy thin film, the Al - 4 . 0Nd -- 1Ta - (Fe, Co). alloy thin film, and so forth, were fabricated (formed) on a glass substrate (Corning #1737, substrate size; 50 mm in diameter, 1 mm in thickness) by DC magnetron sputtering. At this point in time, there were adopted film forming conditions of substrate temperature: 22°C, Ar gas pressure: 2 mTorr, film forming rate: 2 mm / sec, and back pressure: < 5 x 10⁻⁶ Torr. For a sputtering target, use was made of an aluminum-alloy sputtering target of the same composition as those for the Al alloy thin films that are to be obtained, respectively.

The respective melting temperatures of the thin films were measured in the following manner. About 5 mg of the Al - 4.0Nd - (Fe, Co) alloy thin film, the Al - 4.0Nd - 1Ta - (Fe, Co) alloy thin film, and so forth, formed to a thickness 1 µm, were collected after being stripped from the substrate to be measured with a differential thermometer. In this case, the mean value of temperature at the time of the close of film melting in increasing temperature, and temperature at the time of the start of film solidification in decreasing temperature was taken as melting temperature. The thermal conductivity thereof was obtained by conversion from electrical resistivity of the aluminum-alloy thin film formed to a thickness 100 nm. The reflectance was found by measuring reflectance of the respective films 100 nm thick at the laser wave length 650 nm and 405 nm as currently adopted in the case of DVD. Tests on BCA marking property were conducted using a PC (polycarbonate) base plate 0. 6 mm thick as a substrate to fabricate an Al-alloy thin film 70 nm thick although the same film forming conditions as those described above were adopted. At the tests, the thin film was irradiated with laser light (laser marking) under a laser condition of laser wavelength: 810 nm, linear velocity: 4 m / sec, and laser power: 1.5W to thereby evaluate the characteristics on the basis of an effective aperture ratio of portions of the thin film, subjected to the laser marking. Further, for evaluation, use was made of a BCA code recorder POP120 - 8R for DVD-ROM (manufactured by Hitachi Computer Equipment) . In making evaluation of the BCA marking property, described later, those with the effective aperture ratio at not less than 95% is designated as a double circle, those with the effective aperture ratio in a range of 80 to 95% as a circle, those with the effective aperture ratio in a range of 50 to 80% as a triangle, and those with the effective aperture ratio less than 50% as a cross (×). As for corrosion resistance, the respective aluminum-alloy thin films were immersed in a solution of 5% NaCl at 35°C to thereby measure anodic polarization, from which respective pitting initiation potentials (the respective potentials corresponding to current density at 10 µA / cm²) were found to be used as indexes for corrosion resistance.

Results of the measurements (examinations) as described are shown in Table 5. In the "composition" column of Table 5, an Fe-amount, and a Co amount of Al - 4.0Nd - 1Ta - (Fe, Co) refer to values expressed in at. % (atomic %), respectively. That is, Al - 4Nd - Z . Fe (or Co) refers to an Al alloy {Al - Nd - Ta - (Fe, Co) alloy} thin film containing 4.0 at. Nd, together with Z at. % of Fe (or Co) . For example, Al - 4Nd - 1Ta - 3.0Fe refers to an Al alloy containing 4.0 at. % of Nd, and 1.0 at. % of Ta, together with 3.0 at. % of Fe.

As is evident from Table 5, ether Fe or Co has the effect of causing reduction in thermal conductivity. Neither Fe nor Co has the effect of enhancement in corrosion resistance.

If the respective addition amounts of Fe, and Co are less than 1.0 at. %, the effect of reduction in thermal conductivity is small. If the respective addition amounts of Fe, and Co exceed 5.0 at. %, there is an increase in deterioration of reflectance. Based on those results, it is evident that the respective addition amounts of Fe and Co are preferably in a range of 1.0 to 5.0 at. %.

### Inventive Example 5

An Al - 4.0Nd - {In - Li (In, Zn, Ge, Cu, Li)} thin film (a thin film made of an Al alloy containing 4.0 at. % of Nd, together with at least one element selected from the group consisting of elements In - Li), and an Al - 4.0Nd - 1Ta - {In - Li (In, Zn, Ge, Cu, Li)} thin film (a thin film made of an Al alloy containing 4.0 at. % of Nd, and 1.0 % of Ta, together with at least one element selected from the group consisting of elements In - Li), were fabricated, having examined relationships of respective addition amounts of In to Ni, with the melting temperature, thermal conductivity, reflectance, of the respective thin films, corrosion resistance, and BCA marking property, respectively.

The thin films were fabricated as follows. More specifically, the Al - 4.0Nd - (In - Li) thin film, the Al - 4 .0Nd, - 1Ta - (In - Li) thin film, and so forth, were fabricated (formed) on a glass substrate (Corning #1737, substrate size; 50 mm in diameter, 1 mm in thickness) by DC magnetron sputtering. At this point in time, there were adopted film forming conditions of substrate temperature: 22°C, Ar gas pressure: 2 mTorr, film forming rate: 2 mm / sec, and back pressure: < 5 x 10⁻⁶ Torr. For a sputtering target, use was made of an aluminum-alloy sputtering target of the same composition as those for the Al alloy thin films that are to be obtained, respectively.

The melting temperature of the thin films was measured in the following manner. About 5 mg of the aluminum-alloy thin films {the Al - 4.0Nd - (In - Li) thin film, the Al - 4.0Nd - 1Ta - (In - Li) thin film, and so forth}, formed to a thickness 1 µm, were collected after being stripped from the substrate too be measured with a differential thermometer. In this case, the mean value of temperature at the time of the close of film melting in increasing temperature, and temperature at the time of the start of film solidification in decreasing temperature was taken as melting temperature. The thermal conductivity thereof was obtained by conversion from electrical resistivity of the aluminum-alloy thin films formed to a thickness 100 nm. The reflectance was found by measuring reflectance of the respective films 100 nm thick at the laser wave length 650 nm and 405 nm as currently adopted in the case of DVD. Tests on BCA marking property were conducted using a PC (polycarbonate) base plate 0.6 mm thick as a substrate to fabricate an Al-alloy thin film 70 nm thick although the same film forming conditions as those described above were adopted. At the tests, the thin film was irradiated with laser light (laser marking) under a laser condition of laser wavelength: 810 nm, linear velocity: 4 m / sec, and laser power: 1.5W to thereby evaluate the characteristics on the basis of an effective aperture ratio of portions of the thin film, subjected to the laser marking. Further, for evaluation, use was made of a BCA code recorder POP120 - 8R for DVD-ROM (manufactured by Hitachi Computer Equipment) . In making evaluation of the BCA marking property, described later, those with the effective aperture ratio at not less than 95% is designated as a double circle, those with the effective aperture ratio in a range of 80 to 95% as a circle, those with the effective aperture ratio in a range of 50 to 80% as a triangle, and those with the effective aperture ratio less than 50% as a cross (×). As for corrosion resistance, the aluminum-alloy thin films were immersed in a solution of 5% NaCl at 35°C to thereby measure anodic polarization, from which respective pitting initiation potentials (the respective potentials corresponding to current density at 10 µA / cm²) were found to be used as indexes for corrosion resistance.

Results of the measurements (examinations) as described are shown in Table 6. In the "composition" column of Table 6, respective amounts of In - Li of Al - 4.0Nd - 1Ta - (In - Li) refer to values expressed in at. % (atomic %), respectively. That is, Al - 4.0Nd - 1Ta - Z . In (or one element selected from the group consisting of elements Zn, Ge, Cu, and Li) refers to an Al alloy {Al - Nd - Ta - (In - Li) alloy} thin film containing 4.0 at. % of Nd, and 1.0 at. % of Ta, together with Z at. % of In (or one element selected from the group consisting of elements Zn, Ge, Cu, and Li). For example, Al - 4.0Nd - 1Ta - 3.0In refers to an Al alloy containing 4.0 at. % of Nd, and 1.0 at. % of Ta, together with 3.0 at. % of In.

As is evident from Table 6, any of In - Li (In, Zn, Ge, Cu, and Li) has the effect of reduction in melting temperature as well as thermal conductivity. Among In - Li, In and Ge, in particular, have the effect of large reduction in thermal conductivity, and from this point of view, addition of In, Ge is preferable. In - Li have no effect of causing enhancement in corrosion resistance.

If respective addition amounts of In - Li are less than 1.0 at. %, both the effect of reduction in thermal conductivity and the effect of reduction in melting temperature are small. If the respective addition amounts of In - Li exceed 10.0 at. %, this will cause deterioration in reflectance to increase. From these point of view, it is evident that the respective addition amounts of In - Li are preferably in a range of 1.0 to 10.0 at. %.

### Comparative Example 6

An Al - 4.0Nd - 2.0Ta - (Si, Mg) thin film (a thin film made of an Al alloy containing 4.0 at. % of Nd, and 2.0 at. % of Ta, together with at least one element selected from the group consisting of elements Si, and Mg) was fabricated, having examined relationships of respective addition amounts of Si, and Mg, with the melting temperature, thermal conductivity, reflectance, corrosion resistance, and BCA marking property of the thin film, respectively.

The thin film was fabricated as follows. More specifically, the Al - 4. 0Nd - 2. 0Ta - (Si, Mg) alloy thin film was fabricated (formed) on a glass substrate (Corning #1737, substrate size; 50 mm in diameter, 1 mm in thickness) by DC magnetron sputtering. At this point in time, there were adopted film forming conditions of substrate temperature: 22°C, Ar gas pressure: 2 mTorr, film forming rate: 2 mm / sec, and back pressure: < 5 x 10⁻⁶ Torr. For a sputtering target, use was made of an aluminum-alloy sputtering target of the same composition as that for the Al alloy thin film that is to be obtained.

The melting temperature of the thin film was measured in the following manner. About 5 mg of the Al - 4.0Nd - 2.0Ta - (Si, Mg) alloy thin film, formed to a thickness 1 µm, was collected after being stripped from the substrate to be measured with a differential thermometer. In this case, the mean value of temperature at the time of the close of film melting in increasing temperature, and temperature at the time of the start of film solidification in decreasing temperature was taken as melting temperature. The thermal conductivity thereof was obtained by conversion from electrical resistivity of the aluminum-alloy thin film formed to a thickness 100 nm. The reflectance was found by measuring reflectance of the respective films 100 nm thick at the laser wave length 650 nm and 405 nm as currently adopted in the case of DVD. Tests on BCA marking property were conducted using a PC (polycarbonate) base plate 0. 6 mm thick as a substrate to fabricate an Al-alloy thin film 70 nm thick although the same film forming conditions as those described above were adopted. At the tests, the thin film was irradiated with laser light (laser marking) under a laser condition of laser wavelength; 810 nm, linear velocity: 4 m / sec, and laser power: 1.5W to thereby evaluate the characteristics on the basis of an effective aperture ratio of portions of the thin film, subjected to the laser marking. Further, for evaluation, use was made of a BCA code recorder POP120 - 8R for DVD-ROM (manufactured by Hitachi Computer Equipment) . In making evaluation of the BCA marking property, described later, those with the effective aperture ratio at not less than 95% is designated as a double circle, those with the effective aperture ratio in a range of 80 to 95% as a circle, those with the effective aperture ratio in a range of 50 to 80% as a triangle, and those with the effective aperture ratio less than 50% as a cross (×). As for corrosion resistance, the aluminum-alloy thin film was immersed in a solution of 5% NaCl at 35°C to thereby measure anodic polarization, from which a pitting initiation potential (the potential corresponding to current density at 10 µA / cm²) was found to be used as an index for corrosion resistance.

Results of the measurements (examinations) as described are shown in Table 7. In the "composition" column of Table 7, an Nd amount, a Ts amount, an Si amount, and an Mg amount of Al - 4.0Nd - 2.0Ta - (Si, Mg) refer to values expressed in at. % (atomic %), respectively. That is, Al - 4Nd - 2.0Ta - Z - Si (or Mg) refers to an Al alloy (Al - Nd - Ta - (Si, Mg) alloy) thin film containing 4.0 at. % of Nd, and 2.0 at. % of Ta, together with Z at. % of Si (or Mg). For example, Al - 4Nd - 2,0Ta - 5.0Si refers to an Al alloy containing 4.0 at. % of Nd, and 2.0 at. % of Ta, together with 5.0 at. % of Si.

As is evident from Table 7, with an increase in respective addition amounts of Si, and Mg, melting temperature is found decreasing. Further, with addition (inclusion) of Si, the pitting initiation potential is found significantly rising, resulting in enhancement of corrosion resistance. Incidentally, in the case of Al - 2.0Si alloy (comparative example) with only Si added thereto, no rise in the pitting initiation potential thereof is observed. Both Si, and Mg have the effect of reduction in thermal conductivity, but the magnitude of the effect is small.

In the case of the working examples described as above, Nd or Y has been added as the rare earth element, however, even in the case of adding rare earth elements other than Nd, and Y, there can be obtained results of a tendency similar to that for the case of the working examples described as above. Further, with the case of the above- described working examples, any one element of the rare earth element has been added (single addition), and further, any one element selected from the group consisting of elements Cr to Nb, Ni (Cr, Ta, Ti, Mo, V, W, Zr; Hf, Nb, and Ni) has been added (single addition). However, even in the case of adding not less than two elements selected from the group of the rare earth elements (combined addition), and not less than two elements selected from the group consisting of elements Cr to Nb, Ni (combined addition), there can also be obtained results of a tendency similar to that for the case of the working examples described as above.

As the aluminum-alloy reflection film for optical information-recording according to the invention has low thermal conductivity, low melting temperature, and high corrosion resistance, the same can be suitably used for a reflection film for optical information-recording, requiring those properties described, particularly for a reflection film for optical information-recording, capable of coping with laser marking.

**Table 1**

| Composition | Melting temperature (°C) | Electrical resistivity (µΩcm) | Thermal conductivity (W/m·K) | Reflectance @650nm (%) | Reflectance @405nm (%) | BCA marking property |
|---|---|---|---|---|---|---|
| JIS6061 | 654 | 8.0 | 0.93 | 89.3 | 88.6 | × |
| Pure Al | 660 | 3.0 | 2.47 | 90.3 | 91.7 | × |
| Al-0,5Nd | 655 | 5.5 | 1.35 | 90.2 | 91.5 | Δ |
| Al-1.0Nd | 653 | 7.8 | 0.95 | 89.2 | 90.8 | O |
| Al-2.0Nd | 652 | 13.0 | 0.57 | 89.2 | 90.2 | O |
| Al-4.0Nd | 658 | 21.8 | 0.34 | 88.1 | 88.0 | Ⓞ |
| Al-7.0Nd | 650 | 37.0 | 0.20 | 84.3 | 82.3 | Ⓞ |
| Al-10.0Nd | 651 | 50.2 | 0.15 | 81.2 | 79.5 | Ⓞ |
| Al-12.0Nd | 662 | 60.1 | 0.12 | 79.5 | 76.9 | Ⓞ |
| Al-0.5Y | 654 | 4.9 | 1.51 | 90.6 | 91.3 | Δ |
| Al-1.0Y | 661 | 6.5 | 1.14 | 90.1 | 90.7 | ○ |
| Al-5.0Y | 654 | 22.3 | 0.33 | 87.9 | 85.7 | Ⓞ |
| Al-10.0Y | 653 | 46.5 | 0.16 | 82.3 | 79.1 | Ⓞ |
| Al-12.0y | 663 | 54.6 | 0.14 | 80.6 | 77.6 | Ⓞ |

**Table 2**

| Composition | Melting temperature (°C) | Electrical resistivity (µΩcm) | Thermal conductivity (W/m·K) | Pitting initiation potential (mV) | Reflectance @650nm (%) | Reflectance @405nm (%) | BCA marking property |
|---|---|---|---|---|---|---|---|
| Pure Al | 660 | 3.0 | 2.47 | -758 | 90.3 | 91.7 | × |
| Al-4Nd | 658 | 21.8 | 0.34 | -766 | 88.1 | 88.0 | Ⓞ |
| Al-4Nd-0.5Ta | 732 | 23.9 | 0.31 | -612 | 87.2 | 86.8 | Ⓞ |
| Al-4Nd-1.0Ta | 780 | 26.3 | 0.29 | -588 | 86.7 | 85.2 | Ⓞ |
| Al-4Nd-2.0Ta | 865 | 30.6 | 0.25 | -555 | 85.2 | 83.6 | Ⓞ |
| Al-4Nd-3.0Ta | 930 | 35.6 | 0.21 | -483 | 84.0 | 81.4 | O |
| Al-4Nd-5.0Ta | 982 | 47.2 | 0.16 | -420 | 80.8 | 77.3 | O |
| Al-4Nd-7.0Ta | >1000 | 80.3 | 0.12 | -374 | 75.3 | 71.1 | Δ |
| Al-4Nd-0.5Ti | 730 | 24.3 | 0.31 | -630 | 87.1 | 86.8 | Ⓞ |
| Al-4Nd-1.0Ti | 810 | 27.1 | 0.27 | -601 | 85.9 | 85.1 | Ⓞ |
| Al-4Nd-2.0Ti | 850 | 31.2 | 0.24 | -564 | 85.3 | 84.2 | Ⓞ |
| Al-4Nd-5.07Ti | 987 | 47.6 | 0.16 | -441 | 80.2 | 78.6 | ○ |
| Al-4Nd-7.0Ti | >1000 | 61.4 | 0.12 | -384 | 74.2 | 71.3 | Δ |
| Al-4Nd-0.5Cr | 674 | 22.1 | 0.34 | -642 | 86.5 | 86.3 | Ⓞ |
| Al-4Nd-1.0Cr | 695 | 26.1 | 0.28 | -613 | 85.1 | 84.6 | Ⓞ |
| Al-4Nd-2.0Cr | 740 | 30.5 | 0.24 | .576 | 84.6 | 83.5 | Ⓞ |
| Al-4Nd-5.0Cr | 885 | 46.0 | 0.16 | -460 | 79.2 | 76.2 | ○ |
| Al-4Nd-7.0Cr | 940 | 61.4 | 0.12 | -402 | 74.0 | 71.2 | Δ |

**Table 3**

| Composition | Melting temperature (°C) | Electrical resistivity (µΩcm) | Thermal conductivity (W/m·K) | Pitting initiation potential (mV) | Reflectance @650nm (%) | Reflectance @405nm (%) | BCA marking property |
|---|---|---|---|---|---|---|---|
| Pure Al | 660 | 3.0 | 2.47 | -758 | 90.3 | 91.7 | × |
| Al-4Nd | 658 | 21.8 | 0.34 | -766 | 88.1 | 88.0 | Ⓞ |
| Al-4Nd-0,5Zr | 805 | 24.8 | 0.30 | -678 | 85.4 | 85.4 | Ⓞ |
| Al-4Nd-1.0Zr | 880 | 25.8 | 0.29 | -823 | 83.1 | 83.0 | Ⓞ |
| Al-4Nd-2.0Zr | 912 | 29.1 | 0.25 | -601 | 81.0 | 80.2 | Ⓞ |
| Al-4Nd-3.0Zr | 954 | 36.9 | 0.20 | -546 | 78.4 | 76.3 | Ⓞ |
| Al-4Nd-5.0Zr | 980 | 50.2 | 0.15 | -487 | 76.3 | 73.9 | ○ |
| Al-4Nd-7.0Zr | >1000 | 63.7 | 0.12 | -430 | 70.1 | 64.9 | × |
| Al-4Nd-0.5Mo | 683 | 22.6 | 0.33 | -655 | 87.0 | 86.5 | Ⓞ |
| Al-4Nd-1.0Mo | 705 | 23.8 | 0.31 | -631 | 85.2 | 84.1 | Ⓞ |
| Al-4Nd-2.0Mo | 785 | 26.0 | 0.29 | -598 | 82.6 | 81.1 | Ⓞ |
| Al-4Nd-5.0Mo | 856 | 44.2 | 0.17 | .480 | 79.9 | 78.7 | ○ |
| Al-4Nd-0.5W | 712 | 23.8 | 0.31 | -690 | 85.1 | 84.9 | Ⓞ |
| Al-4Nd1.0W | 778 | 27.6 | 0.27 | -671 | 83.2 | 82.7 | Ⓞ |
| Al-4Nd-2.0W | 850 | 32.5 | 0.23 | -623 | 81.3 | 80.0 | Ⓞ |
| Al-4Nd-5.0W | 960 | 54.3 | 0.14 | -501 | 75.2 | 73.1 | ○ |

**Table 4**

| Composition | Melting temperature (°C) | Electrical resistivity (µΩcm) | Thermal conductivity (W/m·K) | Pitting initiation potential (mV) | Reflectance @850nm (%) | Reflectance @405nm (%) | BCA marking property |
|---|---|---|---|---|---|---|---|
| Pure Al | 660 | 3.0 | 2.47 | -758 | 90.3 | 91.7 | × |
| Al-4Nd | 658 | 21.8 | 0.34 | -766 | 88.1 | 88.0 | Ⓞ |
| Al-4Nd-0.5v | 709 | 22.8 | 0.33 | -702 | 85.2 | 85.0 | Ⓞ |
| Al-4Nd-1.0V | 754 | 25.6 | 0.30 | -665 | 83.4 | 83.0 | Ⓞ |
| Al-4Nd-2.0V | 843 | 30.4 | 0.24 | -621 | 81.6 | 80.2 | Ⓞ |
| Al-4Nd-5.0V | 950 | 47.1 | 0.16 | -530 | 77.1 | 75.3 | ○ |
| Al-4Nd-0.5 Hf | 674 | 23.4 | 0.32 | -634 | 86.3 | 86.3 | Ⓞ |
| Al4Nd-.0Hf | 713 | 25.1 | 0.29 | -587 | 84.7 | 84.2 | Ⓞ |
| Al-4Nd-2.0Hf | 762 | 28.3 | 0.26 | -567 | 83.9 | 82.0 | Ⓞ |
| Al4Nd-5.0Hf | 910 | 45.2 | 0.16 | -501 | 79.0 | 78.2 | O |
| Al-4Nd-0.5Nb | 703 | 22.5 | 0.33 | -701 | 85.9 | 85.5 | Ⓞ |
| AlNd-1.0Nb | 742 | 24.3 | 0.30 | -874 | 84.2 | 83.5 | Ⓞ |
| Al-4Nd-2.0Nb | 830 | 27.6 | 0.27 | -587 | 83.1 | 81.8 | Ⓞ |
| Al-4Nd-5.0Nb | 930 | 43.1 | 0.17 | -512 | 78.2 | 16.7 | ○ |
| Al-4Nd-0.5Ni | 662 | 23.4 | 0.32 | -666 | 87.9 | 87.7 | Ⓞ |
| Al-4Nd-1.0Ni | 658 | 28.4 | 0.26 | -623 | 86.5 | 86.0 | Ⓞ |
| Al-4Nd-2.0Ni | 647 | 31.3 | 0.24 | -598 | 85.1 | 83.9 | Ⓞ |
| Al-4Nd-5.0Ni | 678 | 48.6 | 0.15 | -488 | 80.6 | 78.1 | Ⓞ |

**Table 5**

| Composition | Melting temperature (°C) | Electrical resistivity (µΩcm) | Thermal conductivity (W/m·K) | Reflectance @650nm (%) | Pitting initiation potential (mV) | Reflectance @405nm (%) | BCA marking property |
|---|---|---|---|---|---|---|---|
| Al-4.0Nd | 658 | 21.8 | 0.34 | 88.1 | -766 | 88.0 | Ⓞ |
| Al-4Nd-1.0Ta | 780 | 26.3 | 0.29 | 86.7 | -588 | 85.2 | Ⓞ |
| Al-4Nd-2.0Ta | 865 | 30.6 | 0.25 | 85.2 | -555 | 83.6 | Ⓞ |
| Al-4Nd-3.0Ta | 930 | 35.6 | 0.21 | 84.0 | -483 | 81.4 | Ⓞ |
| Al-4.0Nd-1.0Fe | 702 | 27.8 | 0.27 | 86.2 | -754 | 85.0 | Ⓞ |
| Al-4.0Nd-3.0Fe | 803 | 39.8 | 0.19 | 82.3 | -755 | 80.1 | Ⓞ |
| Al-4.0Nd-5.0Fe | 915 | 46.7 | 0.16 | 77.6 | -746 | 74.3 | O |
| Al-4.0Nd-7.0Fe | >1000 | 60.3 | 0.12 | 62.3 | -743 | 58.9 | Δ |
| Al-4.0Nd-2.0Co | 751 | 36.4 | 0.20 | 86.1 | -748 | 84.6 | Ⓞ |
| Al-4.0Nd-1Ta-1.0Fe | 840 | 31.9 | 0.23 | 84.7 | -574 | 81.3 | Ⓞ |
| Al-4.0Nd-1Ta-3.0Fe | 853 | 44.6 | 0.17 | 80.5 | -589 | 76.9 | Ⓞ |
| Al-4.0Nd-1Ta-5.0Fe | 970 | 50.3 | 0.15 | 75.8 | -570 | 71.3 | O |
| Al-4.0Nd-1Ta-7.0Fe | >1000 | 64.2 | 0.12 | 60.5 | -532 | 55.7 | × |
| Al-4.0Nd-1Ta-2.0Co | 890 | 40.2 | 0.19 | 85.5 | -569 | 82.0 | Ⓞ |

**Table 6**

| Composition | Melting temperature (°C) | Electrical resistivity (µΩcm) | Thermal conductivity (W/m·K) | Reflectance @650nm (%) | Pitting initiation potential (mV) | Reflectance @405nm (%) | BCA marking property |
|---|---|---|---|---|---|---|---|
| Pure Al | 660 | 3.0 | 2.47 | 90.3 | -758 | 91.7 | × |
| Al-4Nd | 658 | 21.8 | 0.34 | 88.1 | -766 | 88.0 | Ⓞ |
| Al-4Nd-1.0Ta | 780 | 26.3 | 0.29 | 86.7 | -588 | 85.2 | Ⓞ |
| Al-4Nd-2.0Ta | 865 | 30.6 | 0.25 | 85.2 | -555 | 83.6 | Ⓞ |
| Al-4Nd-3,0Ta | 930 | 35.6 | 0.21 | 84.0 | -483 | 81.4 | Ⓞ |
| Al-4.0Nd-3.0Li | 655 | 28.8 | 0.26 | 85.3 | -787 | 84.8 | Ⓞ |
| Al-4.0Nd-3.0Ge | 640 | 31.3 | 0.24 | 82.1 | -761 | 80.6 | Ⓞ |
| Al-4.0Nd-3.0Zn | 650 | 24.3 | 0.30 | 83.4 | -756 | 81.1 | Ⓞ |
| Al-4.0Nd-3.0Cu | 643 | 23.8 | 0.31 | 86.9 | -746 | 84.9 | Ⓞ |
| Al-4.0Nd-0.5n | 638 | 23.1 | 0.32 | 88.2 | -789 | 86.8 | Ⓞ |
| Al-4.0Nd-1.0ln | 633 | 25.6 | 0.29 | 87,2 | -788 | 86.0 | Ⓞ |
| Al-4.0Nd-3.0ln | 625 | 30.3 | 0.24 | 86.1 | -791 | 85.2 | Ⓞ |
| Al-4.0Nd-10.0ln | 611 | 40.3 | 0.18 | 78.1 | -799 | 76.3 | Ⓞ |
| Al-4Nd-3.0ln-2.0Zr | 911 | 33.6 | 0.22 | 78.9 | -654 | 77.1 | Ⓞ |
| Al-4.0Nd-1Ta-3.0Li | 775 | 33.5 | 0.22 | 83.9 | -595 | 80.9 | Ⓞ |
| Al-4.0Nd-1Ta-3.0Ge | 762 | 36.0 | 0.21 | 80,7 | -587 | 76.8 | Ⓞ |
| Al-4.0Nd-1Ta-3.0Zn | 778 | 35.1 | 0.21 | 82.1 | -576 | 80.1 | Ⓞ |
| Al-4.0Nd-Ta-3.0Cu | 762 | 29.3 | 0.26 | 85.3 | -562 | 83.0 | Ⓞ |
| Al-4.0Nd-Ta-0.5l | 744 | 28.1 | 0.27 | 86.9 | -586 | 86.5 | Ⓞ |
| Al-4.0Nd-1Ta-1.0ln | 763 | 30.0 | 0.25 | 86.0 | -574 | 85.2 | Ⓞ |
| Al-4.0Nd-1Ta-3.0ln | 742 | 35.6 | 0.21 | 84.6 | -561 | 83.0 | Ⓞ |
| Al-4.0Nd-1Ta-10,0ln | 710 | 46.8 | 0.16 | 77.0 | -559 | 72.9 | Ⓞ |

**Table 7**

| Composition | Melting temperature (°C) | Electrical resistivity (µΩcm) | Thermal conductivity (W/m·K) | Pitting initiation potential (mV) | Reflectance @650nm (%) | Reflectance @405nm (%) | BCA marking property |
|---|---|---|---|---|---|---|---|
| Al-4Nd-2.0Ta | 865 | 30.6 | 0.25 | -555 | 85.2 | 83.6 | Ⓞ |
| Al-4Nd-2.0Ta-0.5Si | 852 | 30.5 | 0.25 | -367 | 85.9 | 86.1 | Ⓞ |
| Al-4Nd-2.DTa-1.0Si | 842 | 33.1 | 0.23 | -404 | 85.1 | 85.1 | Ⓞ |
| Al-4Nd-2.0Ta-1.5Si | 828 | 33.8 | 0.22 | -423 | 85.1 | 85.0 | Ⓞ |
| Al-4Nd-2.0Ta-3.0Si | 789 | 38.9 | 0.19 | -430 | 84.3 | 83.9 | Ⓞ |
| Al-4Nd-2.0Ta-5.0Si | 730 | 44.8 | 0.17 | -439 | 82.1 | 80.0 | Ⓞ |
| Al-4Nd-2.0Ta-0.5mg | 855 | 30.3 | 0.24 | -560 | 85.6 | 85.8 | Ⓞ |
| Al-4Nd-2.0Ta-1.0Mg | 846 | 31.5 | 0.24 | -572 | 84.9 | 84.6 | Ⓞ |
| Al-4Nd-2.0Ta-3.0Mg | 836 | 36.8 | 0.20 | -580 | 83.5 | 82.7 | Ⓞ |
| Al-4Nd-2.0Ta-5.0Mg | 801 | 42.6 | 0.17 | -599 | 81.6 | 80.0 | Ⓞ |
| Al-2,0Si | 642 | 4.2 | 1.77 | -732 | 90.1 | 91.6 | × |

## Claims

1. An aluminum-alloy reflection film for optical information-recording, said aluminum-alloy reflection film, containing:
an element Al as the main constituent;
1.0 to 10.0 at. % of at least one element selected from the group of rare earth elements;
0.5 to 5.0 at. % of at least one element selected from the group consisting of elements Cr, Ta, Ti, Mo, V, W, Zr, Hf, Nb, and Ni;
1.0 to 10.0 at. % of at least one element selected from the group consisting of elements In, Zn, Ge, Cu, and Li and optionally 1 to 5 at. % of at least one element of Fe or Co and up to 5 at. % of at least one element selected from Si and Mg.

2. An aluminum-alloy reflection film for optical information-recording according to claim 1, wherein the rare earth elements are elements Nd and/or Y.

3. An aluminum-alloy reflection film for optical information-recording according to claims 1 or 2, containing 1.0 to 5.0 at. % of at least one element selected from the group consisting of elements Fe, and Co.

4. An aluminum-alloy reflection film for optical information-recording according to any of claims 1 to 3, containing not more than 5.0 at. % of at least one element selected from the group consisting of elements Si, and Mg.

5. An optical information-recording medium comprising an aluminum-alloy reflection film for optical information-recording, according to any of claims 1 to 4.

6. An optical information-recording medium according to claim 5, suitable for use in laser marking.

7. An aluminum-alloy sputtering target for formation of an aluminum-alloy reflection film for optical information-recording, containing:
an element Al as the main constituent;
1.0 to 10.0 at. % of at least one element selected from the group of rare earth elements;
0.5 to 5.0 at. % of at least one element selected from the group consisting of elements Cr, Ta, Ti, Mo, V, W, Zr, Hf, Nb, and Ni;
1.0 to 10.0 at. % of at least one element selected from the group consisting of elements In, Zn, Ge, Cu, and Li and optionally 1-5 at. % of at least one element of Fe and Co and up to 5 at. % of at least one element selected from Si and Mg.

8. An aluminum-alloy sputtering target for formation of an aluminum-alloy reflection film for optical information-recording, according to claim 7, containing 1.0 to 5.0 at. % of at least one element selected from the group consisting of elements Fe, and Co.

9. An aluminum-alloy sputtering target for formation of an aluminum-alloy reflection film for optical information-recording, according to any of claims 7 and 8, containing not more than 5.0 at. % of at least one element selected from the group consisting of elements Si, and Mg.

## Patentansprüche

1. Reflektionsfilm aus einer Aluminiumlegierung für die optische Informationsaufzeichnung, wobei dieser Reflektionsfilm aus der Aluminiumlegierung enthält:
ein Element Al als Hauptbestandteil;
1,0 bis 10,0 At.-% von mindestens einem Element, das aus der Gruppe der Seltenerdelemente gewählt ist;
0,5 bis 5,0 At.-% von mindestens einem Element, das aus der Gruppe gewählt ist, die aus den Elementen Cr, Ta, Ti, Mo, V, W, Zr, Hf, Nb und Ni besteht;
1,0 bis 10,0 At.-% von mindestens einem Element, das aus der Gruppe gewählt ist, die aus den Elementen In, Zn, Ge, Cu und Li besteht
und wahlweise 1 bis 5 At.-% von mindestens einem Element von Fe oder Co und bis zu 5 At.-% von mindestens einem Element, das aus Si und Mg gewählt ist.

2. Reflektionsfilm aus einer Aluminiumlegierung für die optische Informationsaufzeichnung nach Anspruch 1, worin die Seltenerdelemente die Elemente Nd und/oder Y sind.

3. Reflektionsfilm aus einer Aluminiumlegierung für die optische Informationsaufzeichnung nach den Ansprüchen 1 oder 2, der 1,0 bis 5,0 At.-% von mindestens einem Element enthält, das aus der Gruppe gewählt ist, die aus den Elementen Fe und Co besteht.

4. Reflektionsfilm aus einer Aluminiumlegierung für die optische Informationsaufzeichnung nach einem der Ansprüche 1 bis 3, der nicht mehr als 5,0 At.-% von mindestens einem Element enthält, das aus der Gruppe gewählt ist, die aus den Elementen Si und Mg besteht.

5. Optisches Informationsaufzeichnungsmedium, das einen Reflektionsfilm aus einer Aluminiumlegierung für die optische Informationsaufzeichnung umfasst, nach einem der Ansprüche 1 bis 4.

6. Optisches Informationsaufzeichnungsmedium nach Anspruch 5, das für die Anwendung in der Lasermarkierung geeignet ist.

7. Sputtertarget aus einer Aluminiumlegierung zur Bildung eines Reflektionsfilms aus einer Aluminiumlegierung für die optische Informationsaufzeichnung, enthaltend:
ein Element Al als Hauptbestandteil;
1,0 bis 10,0 At.-% von mindestens einem Element, das aus der Gruppe der Seltenerdelemente gewählt ist;
0,5 bis 5,0 At.-% von mindestens einem Element, das aus der Gruppe gewählt ist, die aus den Elementen Cr, Ta, Ti, Mo, V, W, Zr, Hf, Nb und Ni besteht;
1,0 bis 10,0 At.-% von mindestens einem Element, das aus der Gruppe gewählt ist, die aus den Elementen In, Zn, Ge, Cu und Li besteht
und wahlweise 1 bis 5 At.-% von mindestens einem Element von Fe oder Co und bis zu 5 At.-% von mindestens einem Element, das aus Si und Mg gewählt ist.

8. Sputtertarget aus einer Aluminiumlegierung für die Bildung eines Reflektionsfilms aus einer Aluminiumlegierung für die optische Informationsaufzeichnung nach Anspruch 7, der 1,0 bis 5,0 At.-% von mindestens einem Element enthält, das aus der Gruppe gewählt ist, die aus den Elementen Fe und Co besteht.

9. Sputtertarget aus einer Aluminiumlegierung für die Bildung eines Reflektionsfilms aus einer Aluminiumlegierung für die optische Informationsaufzeichnung nach einem der Ansprüche 7 und 8, der nicht mehr als 5,0 At.-% von mindestens einem Element enthält, das aus der Gruppe gewählt ist, die aus den Elementen Si und Mg besteht.

## Revendications

1. Film de réflexion en alliage d'aluminium destiné à l'enregistrement optique d'informations, ledit film de réflexion en alliage d'aluminium contenant :
un élément Al en tant que constituant principal;
de 1,0 à 10,0 % at. d'au moins un élément choisi parmi le groupe des éléments des terres rares ;
de 0,5 à 5,0 % at. d'au moins un élément choisi parmi le groupe consistant en les éléments Cr, Ta, Ti, Mo, V, W, Zr, Hf, Nb, et Ni ;
de 1,0 à 10,0 % at. d'au moins un élément choisi parmi le groupe consistant en les éléments In, Zn, Ge, Cu, et Li ; et
facultativement de 1 à 5 % at. d'au moins un élément du Fe ou du Co et jusqu'à 5 % at. d'au moins un élément choisi parmi le Si et le Mg.

2. Film de réflexion en alliage d'aluminium destiné à l'enregistrement optique d'informations selon la revendication 1, dans lequel les éléments des terres rares sont les éléments Nd et/ou Y.

3. Film de réflexion en alliage d'aluminium destiné à l'enregistrement optique d'informations selon les revendications 1 ou 2, contenant de 1,0 à 5,0 % at. d'au moins un élément choisi parmi le groupe consistant en les éléments Fe et Co.

4. Film de réflexion en alliage d'aluminium destiné à l'enregistrement optique d'informations selon l'une quelconque des revendications 1 à 3, ne contenant pas plus de 5,0 % at. d'au moins un élément choisi parmi le groupe consistant en les éléments Si et Mg.

5. Support d'enregistrement optique d'informations comprenant un film de réflexion en alliage d'aluminium destiné à l'enregistrement optique d'informations, selon l'une quelconque des revendications 1 à 4.

6. Support d'enregistrement optique d'informations selon la revendication 5, approprié pour une utilisation en marquage au laser.

7. Cible de pulvérisation en alliage d'aluminium destinée à la formation d'un film de réflexion en alliage d'aluminium destiné à l'enregistrement optique d'informations, contenant :
un élément Al en tant que constituant principal ;
de 1,0 à 10,0 % at. d'au moins un élément choisi parmi le groupe des éléments des terres rares ;
de 0,5 à 5,0 % at. d'au moins un élément choisi parmi le groupe consistant en les éléments Cr, Ta, Ti, Mo, V, W, Zr, Hf, Nb, et Ni ;
de 1,0 à 10,0 % at. d'au moins un élément choisi parmi le groupe consistant en les éléments In, Zn, Ge, Cu, et Li ; et
facultativement de 1 à 5 % at. d'au moins un élément du Fe ou du Co et jusqu'à 5 % at. d'au moins un élément choisi parmi le Si et le Mg.

8. Cible de pulvérisation en alliage d'aluminium destinée à la formation d'un film de réflexion en alliage d'aluminium destiné à l'enregistrement optique d'informations, selon la revendication 7, contenant de 1,0 à 5,0 % at. d'au moins un élément choisi parmi le groupe consistant en les éléments Fe et Co.

9. Cible de pulvérisation en alliage d'aluminium destinée à la formation d'un film de réflexion en alliage d'aluminium destiné à l'enregistrement optique d'informations, selon l'une quelconque des revendications 7 et 8, ne contenant pas plus de 5,0 % at. d'au moins un élément choisi parmi le groupe consistant en les éléments Si et Mg.
